(19) **Europäisches Patentamt**
**European Patent Office**
**Office européen des brevets**

(11) **EP 1 579 425 B1**

(12) **EUROPEAN PATENT SPECIFICATION**

(45) Date of publication and mention
of the grant of the patent:
**14.12.2011 Bulletin 2011/50**

(51) Int Cl.:
***G10L 19/00*** (2006.01)

(21) Application number: **03796219.8**

(86) International application number:
**PCT/IB2003/006217**

(22) Date of filing: **29.12.2003**

(87) International publication number:
**WO 2004/059894 (15.07.2004 Gazette 2004/29)**

(54) **METHOD AND DEVICE FOR COMPRESSED-DOMAIN PACKET LOSS CONCEALMENT**

VERFAHREN UND EINRICHTUNG ZUM VERBERGEN VON PAKETVERLUSTEN IM
KOMPRIMIERTEN BEREICH

PROCEDE ET DISPOSITIF DE DISSIMULATION D'ERREURS PAR PERTE DE PAQUETS DU
DOMAINE COMPRIME

(84) Designated Contracting States:
**AT BE BG CH CY CZ DE DK EE ES FI FR GB GR
HU IE IT LI LU MC NL PT RO SE SI SK TR**

(30) Priority: **31.12.2002 US 335543**

(43) Date of publication of application:
**28.09.2005 Bulletin 2005/39**

(73) Proprietor: **Nokia Corporation
02150 Espoo (FI)**

(72) Inventors:
• **WANG, Ye**
**129792 Kent Vale (SG)**
• **OJANPERA, Juha**
**FIN-33710 Tampere (FI)**
• **KORHONEN, Jari**
**33230 Tampere (FI)**

(74) Representative: **Piotrowicz, Pawel Jan Andrzej et al**
**Venner Shipley LLP
20 Little Britain
London EC1A 7DH (GB)**

(56) References cited:
EP-A- 0 746 116          WO-A-98/13965
DE-A1- 4 111 131        US-A- 5 862 518
US-A- 5 928 379         US-A1- 2002 126 988
US-B1- 6 327 689        US-B1- 6 490 243

• KORHONEN J ET AL: "Schemes for error resilient streaming of perceptually coded audio" MULTIMEDIA AND EXPO, 2003. PROCEEDINGS. 2003 INTERNATIONAL CONFERENCE ON 6-9 JULY 2003, PISCATAWAY, NJ, USA,IEEE, vol. 3, 6 July 2003 (2003-07-06), pages 165-168, XP010651180 ISBN: 0-7803-7965-9
• KORHONEN J. ET AL.: 'Error robustness scheme for perceptually coded audio based on interframe shuffling of samples' PROC. OF IEEE ICASSP 2002 May 2002, ORLANDO, FL, USA, pages 2053 - 2056, XP008047245
• BRANDENBURG K. ET AL.: 'ISO_MPEG_1 audio: a generic standard for coding of high-quality digital audio' 92ND CONVENTION OF THE AUDIO ENGINEERING SOCIETY 24 March 1992, VIENNA, AUSTRIA, pages 780 - 792, XP000978167

## Description

Field of the Invention

The present invention relates generally to error concealment and, more particularly, to packet loss recovery for the concealment of transmission errors occurring in digital audio streaming applications.

Background of the Invention

If a streaming medium is available in a mobile device, a user can use the mobile device for listening to music, for example. For music listening application, audio signals are generally compressed into digital packet formats for transmission. The transmission of compressed digital audio, such as MP3 (MFEG-1/2 layer 3), over the Internet has already had a profound effect on the traditional process of music distribution. Recent developments in the audio signal compression field have rendered streaming digital audio using mobile terminals possible. With the increase in network traffic, a loss of audio packets due to traffic congestion or excessive delay in the packet network is likely to occur. Moreover, the wireless channel is another source of errors that can also lead to packet losses. Under such conditions, it is crucial to improve the quality of service (QoS) in order to induce widespread acceptance of music streaming applications.

To mitigate the degradation of sound quality due to packet loss, various prior art techniques and their combinations have been proposed. UEP (unequal error protection), a subclass of forward error correction (FEC), is one of the important concepts in this regard. UEP has been proven to be a very effective tool for protecting compressed domain audio bitstreams, such as MPEG AAC (Advanced Audio Coding), where bits are divided into different classes according to their bit error sensitivities. Using UEP for error concealment of percussive sound has been disclosed in U.S. Patent Application Publication Number US2004/0083 110A1.

In another approach, Korhonen ("Error Robustness Scheme for Perceptually Coded Audio Based on Interframe Shuffling of Samples", Proc, of IEEE International Conference on Acoustics, Speech and Signal Processing 2002, Orlando Florida, pp. 2053-2056, May 2002) separates an audio frame to two parts: a critical data part and a less critical data part. The payload including the critical data part is transported via a reliable means, such as TCP (Transmission Control Protocol), while the less critical data part is transported by such means as UDP (User Datagram Protocol).

However, due to the error characteristics of mobile IP networks and the constraints on latency, packet delivery in the various UEP schemes and the selective retransmission schemes is still not very reliable. Especially when errors are due to packet losses in the congested IP networks, bit errors in wireless air interface, and hand-over in cellular networks. Thus, it is advantageous and desirable to provide a robust method and system for high quality audio streaming over packet networks, such as mobile IP networks, 2.5G and 3G networks and bluetooth. Such method and system must take into account the required computational complexity and memory/power consumption.

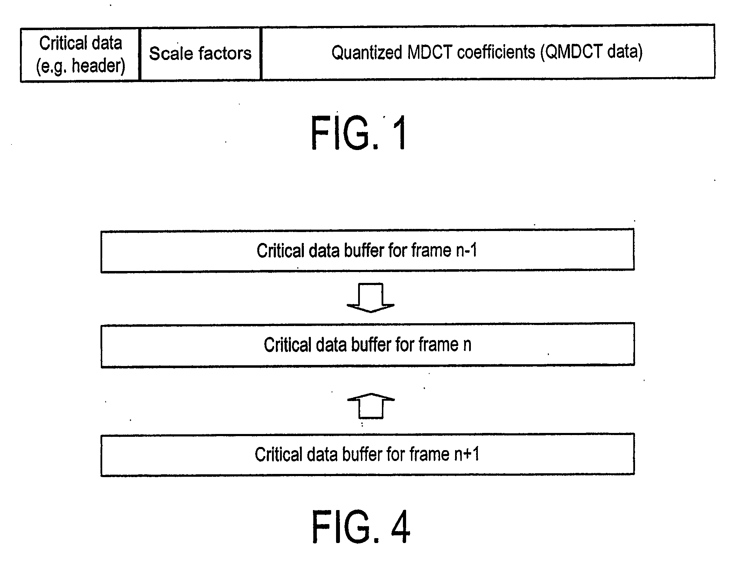

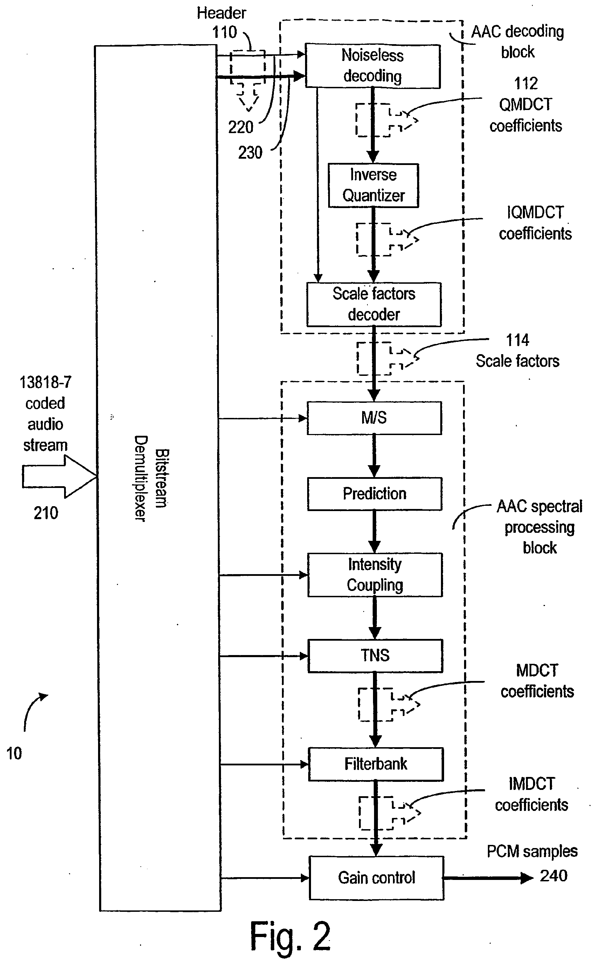

MPEG-2/MPEG-4 AAC coders and their related data structure are known in the art. The data structure of an AAC frame is shown in Figure 1. The frame comprises a critical data part (e.g. header), the scale factors and Quantized Modified Discrete Cosine Transform coefficients (QMDCT data). An MPEG-2 decoder is shown in Figure 2. As shown, the decoder **10** comprises a bitstream demultiplexer for receiving a 13818-7 coded audio stream 200 and providing signals (thinner lines) and data (thick line) 1o various decoding tools in the decoder. The tools in the decoder **10** comprise again control module, an AAC spectral processing block and an AAC decoding block. As shown in Figure 2, the critical data part **110** in an AAC frame can be obtained from the signals **220** and data **230** provided by the bitstream demultiplexer. The QMDCT data **112** can be obtained from the output of the noiseless decoding tool. The scale factors **114** can be obtained from the output of the scale factors decoding tool. In prior art, error concealment is mostly carried out in the time domain (PCM sample **240,** for example, as described in WO98/13965) or spectral domain (MDCT and IMDCT coefficients, for example). The prior art solutions require more on memory, computation and power consumption. When audio streaming is carried out in a mobile terminal, it is desirable to use an error concealment method where memory requirement, computation complexity and power consumption can be substantially reduced.

WO98/13965 A1 describes a digital audio receiver which stores received frames temporarily for decoding and error concealment. A reconstructing block in the decoder reads stored frames using a read window wherein the latest received frame is undecoded. Decoding is carried out in stages so that the correctness of the current frame is examined and possible errors are concealed using corresponding data of other frames in the window. Detection of errors is based on checksums and allowed values of bit combinations in certain parts of the frame. In addition, the receiver maintains an estimate for the signal's bit error ratio and uses it to control the operation of the error concealment algorithm.

"An Overview of Mpeg-4 Audio Version 2" by Heiko Purnhagen (1999) gives a brief overview of the MPEG-4 Audio Standard and the audio tools available. It also describes in more detail the audio tools added in Version 2.

Summary of the Invention

The present invention provides a method and device for error concealment of transmission errors occurring in digital audio streaming. Moore specifically, packet loss due to transmission are recovered in the compressed domain.

Thus, according to the first aspect of the present invention, there is provided an audio decoder, as defined in claim 1 appended hereto.

According to the second aspect of the present invention, there is provided a method of decoding a bitstream, as defined in claim 11 appended hereto.

The present invention will become apparent upon reading the description taken in conjunction with Figures 3 to 13.

Brief Description of the Drawings

Figure 1 is a block diagram illustrating the data structure of an AAC frame.

Figure 2 is a block diagram illustrating a prior art MPEG-2 AAC decoder.

Figure 3 is a flowchart illustrating the method of error concealment, according to the present invention.

Figure 4 is a schematic representation showing the recovery of a corrupted critical data part of an AAC frame.

Figure 5 is a schematic representation showing the recovery of lost scale factors.

Figure 6 is a plot showing long-windowed scale factors of left and right channels of an AAC frame.

Figure 7 is a plot showing another example of long-windowed scale factors.

Figure 8 is a plot showing short-windowed scale factors of two adjacent AAC frames

Figure 9 is schematic representation showing a scale factor vector in an AAC frame.

Figure 10 is a schematic representation showing the search process to estimate a missing coded scale factor.

Figure 11 a is a plot showing QMDCT coefficients in one of the stereo channels of an AAC frame.

Figure 11b is a s plot showing QMDCT coefficients in another of the stereo channels of the AAC frame.

Figure 12 is a block diagram illustrating a receiver capable of carrying out the error concealment method, according to the present invention.

Figure 13 is a block diagram showing a mobile terminal having an error concealment module, according to the present invention.

Best Mode to Carry Out the Invention

After applying various UEP (unequal error protection) schemes, the situation in the receiver side is likely to be that the most packet loss occurs in the QMDCT (Quantized Modified Discrete Cosine Transform) data in an AAC frame. Some packet loss occurs in the AAC scale factors. In rare situations, packet loss can occur in the critical data, or the AAC header and global_gain. If the critical data is loss, it is very difficult to decode the rest of that AAC frame.

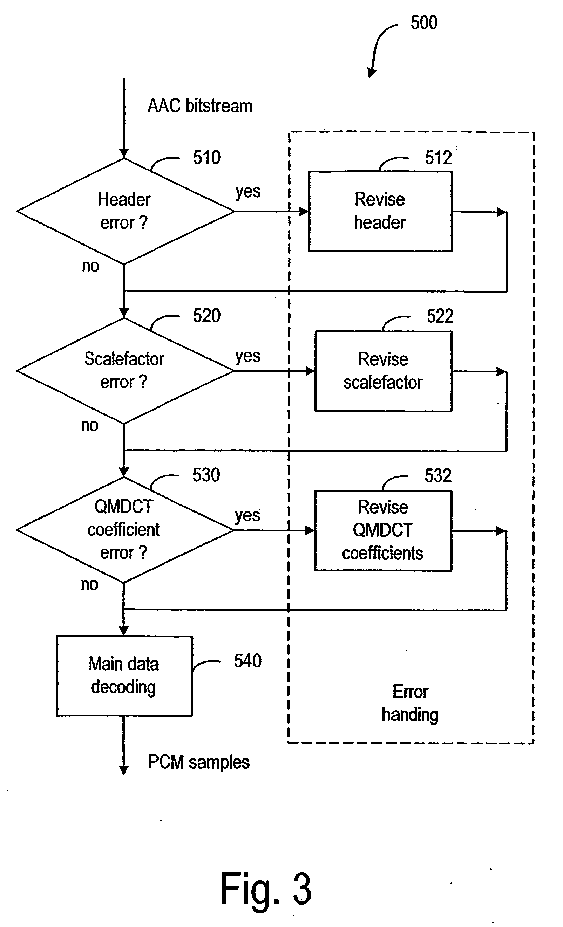

Thus, the present invention carries out error concealment directly in the compressed domain. More particularly, the present invention conceals errors in three separate parts of the AAC frame: the critical data part including the header and the global_gain, the QMDCT data and the scale factors. The error concealment method, according to the present invention, is illustrated in the flowchart 500 of Figure 3. After the coded audio bitstream is sorted by the bitstream demultiplexer (Figure 2), data **110** indicative of the header and global gain in an AAC frame, data **112** indicative of the QMDCT coefficients, and data **114** indicative of the scale factors are obtained and examined for error concealment purposes. At step **510,** data **110** is checked to determine whether an error occurs in the header and global_gain. If an error occurs, the AAC bitstream is routed to an error handler, where the header/global_gain error is corrected at step **512.** If there is no error in the header/global_gain data, data **112** is checked to determine, at step **520,** whether an error occurs in the QMDCT coefficients. If an error occurs, the AAC bitstream is routed to the error handler where the error in QMDCT coefficients is corrected at step **522.** It is followed that the data **114** is checked to determine, at step **530,** whether an error occurs in the scale factors. If so, the error in the scale factors is corrected at step **532.** After these error concealment steps, the error-concealed AAC bitstream is decoded by a data decoder at step **540** to become PCM samples.

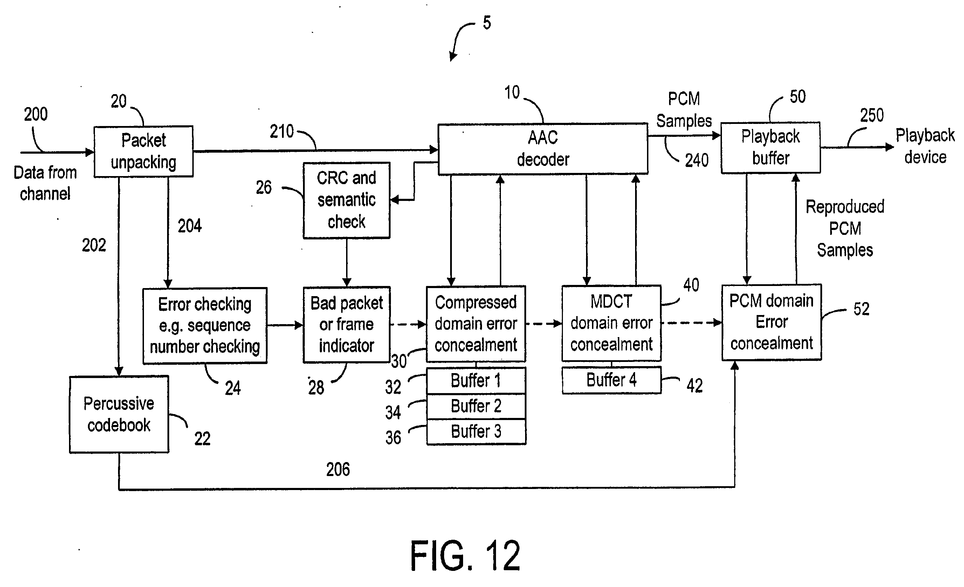

For concealing errors in data **110, 112** and **114** in a current AAC frame, it is preferred that corresponding data in at least one previous frame is stored in a buffer. A receiver capable of carrying out the present invention is shown in Figure 12.

Because the data indicative of the AAC header and global_gain is the most critical data in error concealment, the protection of this critical data must be emphasized. The protection can be achieved by a number of ways as described below.

1) The critical data can be transmitted in advance, before the streaming starts. In this way, the occurrence of packet loss is most likely in the QMDCT data and the scale factors.
2) The critical data is protected by a selective re-transmission scheme. Because the critical data occupies less than 10% of the bits in most AAC bitstreams, a network-based re-transmission scheme will not reduce the transmission bandwidth significantly.
3) The critical data is embedded in multiple packets as ancillary data in the sender side.

With any one of these methods, the critical data of one or more frames can be stored in the receiver side. In case the packet loss is in the critical data, at least part of the critical data can be derived from neighboring frames based on their statistical characteristics and data structures. For example, the MDCT window_sequence of a frame **n** can be determined from the corresponding data in frames **n-1** and **n+1.** Likewise, the window_shape can be reliably estimated from the neighboring frames. Regarding the global_gain, it is preferred that the smaller one of the global_gain values in the neighbor frames **n-1** and **n+1** be used to replace the missing value in the frame **n.** The criterion reflects the fact that a fill-in sound segment that results in a dip is perceptually more pleasant than that of a surge, according to psychoacoustics. The critical data buffer for error concealment in the critical data is shown in Figure 4.

After the critical data in the corrupted frame **n** is derived based on the critical data in frame **n-1** and frame **n+1** and the derived critical data is stored, there are at least two ways to generate the fill-in:

> 1. Estimate the missing scale factors and QMDCT data for frame **n** from neighboring frames as described later herein.
> 2. Mute the entire frame **n** in the compressed domain by setting the scale factors and the QMDCT coefficients in the frame to zero, and conceal the errors in the MDCT domain or PCM domain (see Figures 2 and 12).

If the packet loss is in the AAC scale factors only (i.e., the AAC header and the global_gain in the same frame are available), then the global_gain and the Huffman table can be used to code the individual scale factors. Furthermore, the sections with zero scale factors can be obtained from the section_data and the maximum value in each data section. As such, it is possible to estimate the individual DPCM (differential pulse code modulation) scale-factor and even the entire scale-factors in the AAC frame. The basic methodology for estimating the missing data is a partial pattern matching approach.

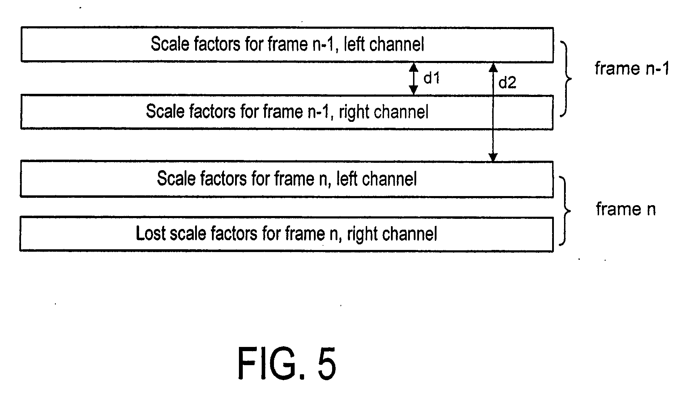

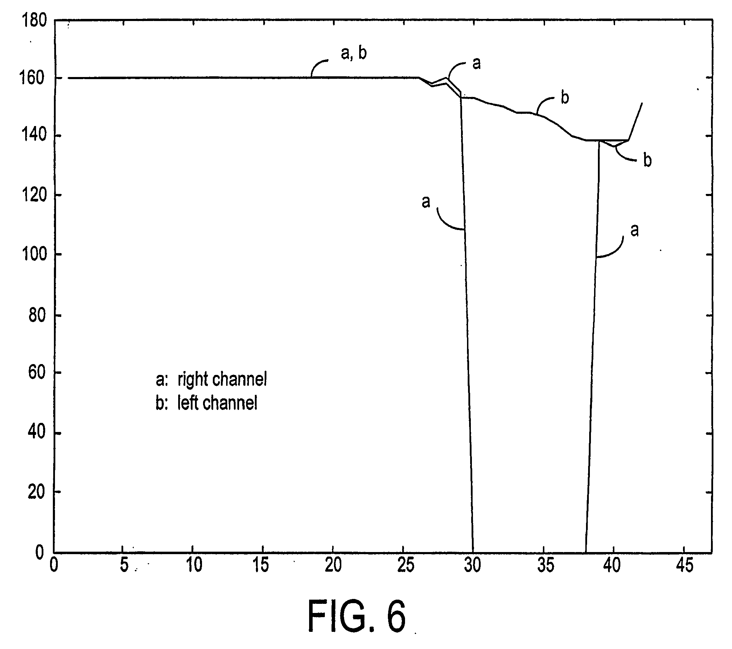

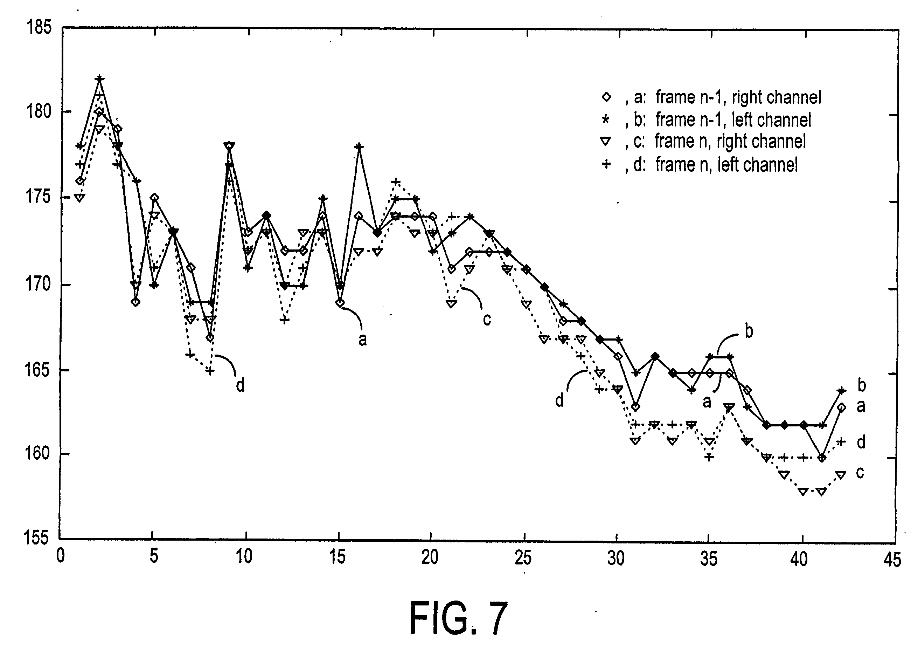

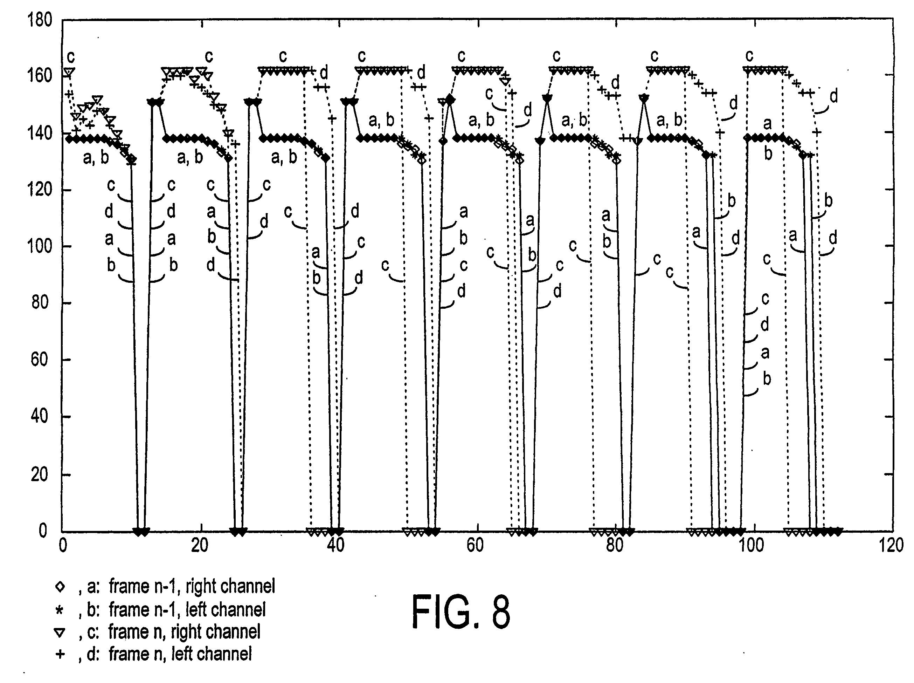

The errors in the scale factors can occur in different ways: 1). The entire scale factors in an AAC frame are lost; 2) a section of the scale factors in the AAC frame is lost; and 3) an individual scale factor in the AAC frame is lost. When all scale factors in an AAC frame are lost, the missing scale factors can be calculated based on one or more neighboring frames, as shown in Figure 5. Figure 5 shows the situation when stereo music is coded, and thus a frame has two channels. By considering the scale vectors in each channel as a vector, the contours of neighboring vectors can be used to decide whether the inter-frame or the inter-channel correlation is dominant. If inter-channel correlation is higher than inter-frame correlation, the missing scale factor vector is replaced by the adjacent channel scale factor vector, and vice versa. It should be noted that because the dimension of the scale_factors vectors of long windows is different from that of short windows, it is necessary to store the scale_factors vectors for both long and short windows for error concealment purposes. Figures 6 and 7 show examples of long-windowed scale factors, and Figure 8 shows an example of short-windowed scale factors of two AAC frames of an audio bitstream. In Figures 6, 7 and 8, the first scale_factor is used to present the global_gain. If the scale factors of the short windows are lost, they should be recovered using the stored short-windowed scale factors. Likewise, if the scale factors of the long windows are lost, they should be recovered using the stored long-windowed scale factors.

Excluding the first scale factor, which is the global_gain, we calculate the partial Euclidian distance $d_{x,y}$ between two channels $x, y$ as follows:

$$d = \sum_{i=1}^{N} \sqrt{(SCF_{x,i} - SCF_{y,i} - c)^2 \cdot w_i},$$

where $N$ is the number of scale factors in a channel, $SCF$ is an individual scale factor, $w$ is a percecptual weighting factor and $c = G_x, - Gy$ and $G_x, G_y$ are global_gains of channels $x$ an $y$. For more sophisticated implementation, $c$ can be derived with a search method to yield the minimum distance between the two channels.

For example, if a section or all of the scale factors for the right channel of frame $n$ are lost, the partial Euclidian distance $d_1$ between the left and right channels of frame $n$-1 and the partial Euclidian distance $d_2$ between the left channel of frame $n$-1 and the left channel of frame $n$ are computed in order to decide whether inter-channel correlation or inter-frame correlation is used for error concealment purposes. If $d_1 > d_2$ (or $lag$=2), then inter-frame correlation should be used and the lost scale factors in the right channel of frame $n$ should be recovered based on the scale factors in the right channel of frame $n$-1. If $d_1 < d_2$ (or $lag$=1), then inter-channel correlation should be used and the lost scale factors in the right channel of frame $n$ should be recovered based on the scale factors in the left channel of frame $n$. Before replacing the missing scale factors with the stored ones, some adjustments may be necessary in order to prevent any false energy surge or to avoid creating false salient frequency components. For example, the global_gain offset, $c$, between two channels should be taken into account.

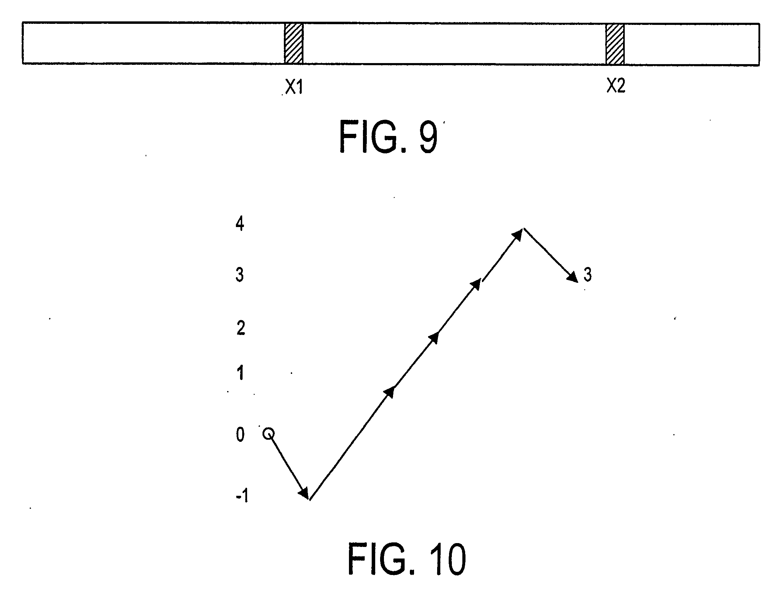

If an individual scale factor in an AAC frame is lost and its position is known, it is possible to estimate the missing DPCM coded scale factor if the scale factors in one or more neighboring frames are not corrupted. Without losing generality, we assume that two individual scale factors are missing, as shown in Figure 9. In Figure 9, the missing scale factors $x_1, x_2$ are shown as the shaded areas, each located between vectors (blank areas) of uncorrupted scale factors in the same frame. We can decode the scale factors in the frame until the first missing scale factor $x_1$ occurs. Although the data between $x_1$ and $x_2$ are correct, they cannot be used directly because of the nature of DPCM coding. However, a search method can be used to estimate the missing scale factor $x_1$, as shown in Figure 10. The search starts from zero, because it is the most likely value of the missing scale factor $x_1$, and stops at the scale factor before $x_2$. At each step, a partial Euclidian distance is calculated and, among the calculated values, the minimum Euclidian distance is used to estimate the missing scale factor $x_1$. In the search, as shown in Figure 10, the minimum Euclidian distance is found at the 6th step and the missing scale factor $x_1$ is 3. The missing scale factor $x_2$ can be determined in a similar manner.

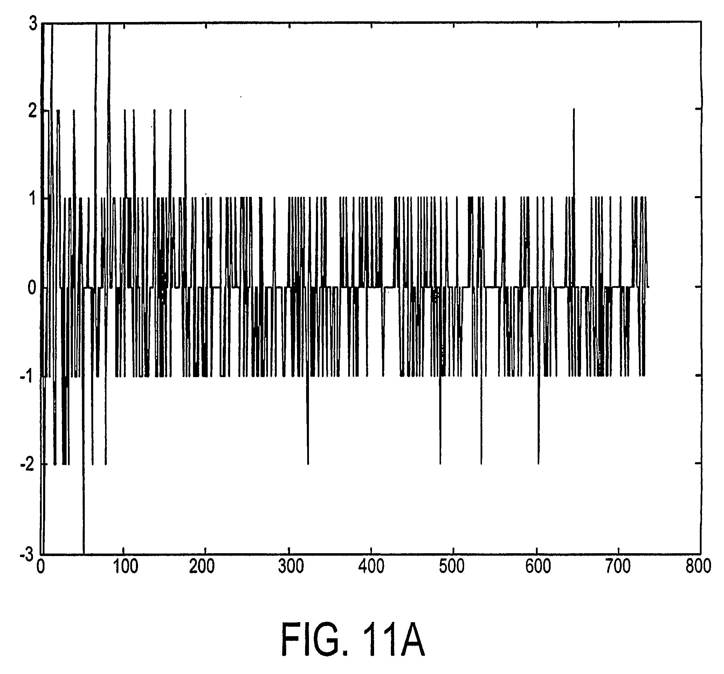

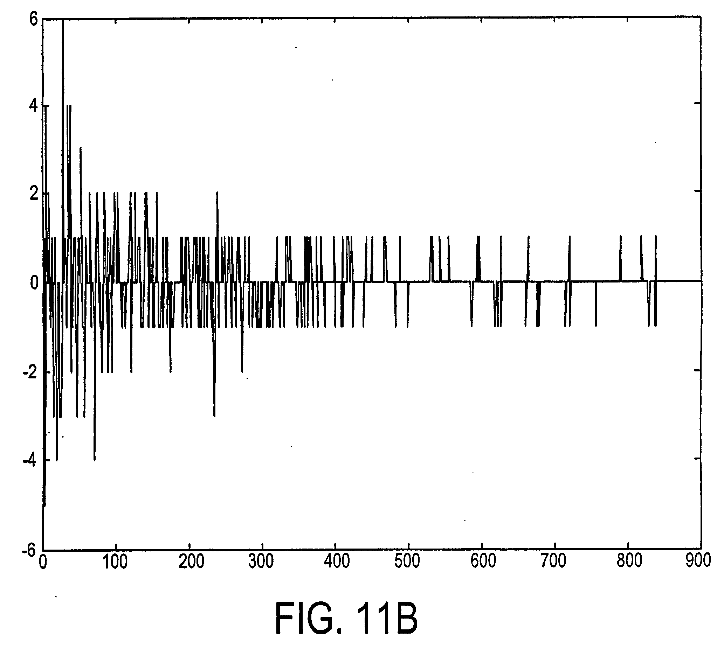

The most frequent situation in packet loss is that the QMDCT coefficients are corrupted or lost, but the header and the scale factors are available. In this situation, the partial pattern matching approach can also be used to recover the lost QMDCT coefficients. An example of QMDCT coefficients of an AAC frame is shown in Figures 11a and 11b. During audio streaming, a feature vector (FV) based on the QMDCT coefficients of a received frame is continuously calculated. The features used in conjunction with the error concealment method are maximum absolute value, mean absolute value and the bandwidth (the number of non-zero values). The QMDCT coefficients of two stereo channels in an AAC frame are separately shown in Figures 11a and 11b. As shown, the large values are usually concentrated in the low frequency region. In order to recover the lost QMDCT coefficients in a frame, the QMDCT coefficients are divided into two frequency regions based on their means and variance. In the low frequency region, it is preferred that a time domain correlation method is used to recover the generally big values. For example, if the QDMCT coefficients are missing, they can be replaced by the corresponding coefficients in the likely correlated QMDCT vector. Here feature vector is used to find out the likely correlation. In the high frequency region, however, a different method is preferred.

In order to recover the QMDCT in the high frequency region, two situations are assumed. If the entire QMDCT coefficients of a frame are lost (max 1024), it is preferred that the buffered information alone is used to recover the missing QMDCT coefficients. The *lag* value (1 or 2) using the autocorrelation of the FVs in the previous frame is calculated in order to determine whether inter-channel or inter-frame correlation should be used. Based on the *lag* value, it can be determined whether a different channel of the same frame or the same channel of a different frame is used. With *lag* values calculated from frames, it is also possible to determine which previous frame is to be used to replace the missing one. In order to prevent the fill-in QMDCT coefficients from exceeding the maximum value as defined by the Huffman codebook being used, the fill-in QMDCT coefficients should be clipped. The entire fill-in QMDCT coefficients can be decreased by a constant, for example, so that there will not be an energy surge in the fill-in frame.

If only an isolated cluster of QMDCT coefficients (a cluster of 2 or 4, for example) in the high frequency region is lost, the simplest way to conceal the errors is to replace all the missing QMDCT coefficients with zeros.

In a situation where only an isolated cluster of QMDCT coefficients in the low frequency region is lost, inter-frame correlation can be used to check the partial Euclidian distance with neighboring frames, and the fill-in coefficients are modified by a decreasing factor in order to prevent a false energy surge from occurring.

Figure 12 is a block diagram showing an AAC decoder at the receiver side, which is capable of carrying out error concealment in the compressed domain, according to the present invention, as well as error concealment in the MDCT domain. Furthermore, it is capable of concealing errors in percussive sounds in the PCM domain, as discussed in copending U.S. Patent Application Serial No. 10/281,395. As shown in Figure 12, at the receiver side **5**, a packet unpacking module **20** is used to convert the packet data **200** into an AAC bitstream **210**. Information **202** indicative of a codebook is provided to a percussive codebook buffer **22** for storage. At the same time, information **204** indicative of a packet sequence number is provided to an error checking module **24** in order to check whether a packet is missing. If so, the error checking module **24** informs a bad frame indicator **28** of the loss packet. The bad frame indicator **28** also indicates which element in the percussive codebook should be used for error concealment. Based on the information provided by the bad frame indicator **28,** a compressed domain error concealment unit **30** provides information to an AAC decoder **10** indicative of corrupted or missing audio frames. In parallel, a code-redundancy check (CRC) module **26** is used to detect a bitstream error in the decoder **10.** The CRC module **26** provides information indicative of a bitstream error to the bad frame indicator **28.** A plurality of buffers **32, 34** and **36,** operatively connected to the compressed domain error concealment module **30,** are used to store data indicative of the header and global_gain, the scale factors and the QMDCT coefficients. Depending on what data parts are missing in an AAC frames, the data in the buffers **32,** 34 and **36** are used to derive or compute the missing data parts. Advantageously, a buffer **42** is also provided in order to store MDCT coefficients and an MDCT domain error concealment module **40** is used to conceal the errors if the scale factors and QMDCT data of the bad frame are set to zero. After errors in the AAC bitstream **210** are concealed in the compressed domain or the MDCT domain, the AAC decoder **10** decodes the AAC bitstream into PCM samples **240**. Based on information indicative of percussive sound as provided by the playback buffer **50,** a PCM domain error concealment unit **52** uses the codebook element **206** provided by the percussive code buffer **22** to reconstruct the corrupted or missing percussive sounds. The error-concealed PCM samples **250** are provided to a playback device.

It should be noted that the receiver **5,** as described above, also includes error concealment modules and buffers to reconstruct the corrupted or missing percussive sounds in an audio bitstream. The detail of percussive sound recovery has been disclosed in the copending U.S. Patent Application Serial 10/281, 395. However, the method and device for compressed-domain packet loss concealment, according to the present invention, can be implemented without the percussive sound recovery scheme.

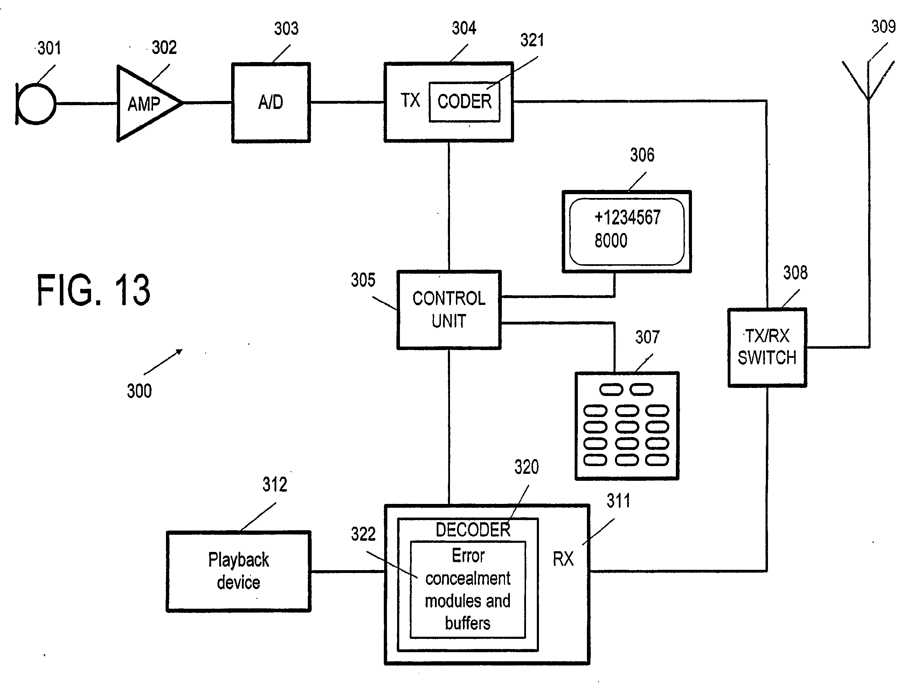

The error concealment method and device, can be used in a mobile terminal, as shown in Figure 13. Figure 13 shows a block diagram of a mobile terminal **300** according to one exemplary embodiment of the invention. The mobile terminal **300** comprises parts typical of the terminal, such as a microphone **301,** keypad **307,** display **306,** transmit/receive switch **308,** antenna **309** and control unit **305.** In addition, Figure 13 shows transmitter and receiver blocks **304, 311** typical of a mobile terminal. The transmitter block **304** comprises a coder **321** for coding the speech signal. The transmitter block **304** also comprises operations required for channel coding, deciphering and modulation as well as RF functions, which have not been drawn in Figure 13 for clarity. The receiver block **311** comprises a decoding block **320** which is capable of receiving compressed digital audio data for music listening purposes, for example. Thus, the decoding block **320** comprises a decoder, similar to the AAC decoder **10,** and error concealment modules/buffers **322** similar to the compressed domain error concealment module **30,** MDCT domain error concealment module **40** and buffers **32, 34, 36, 42** as shown in Figure 12. The signal coming from the microphone **301,** amplified at the amplification stage **302** and digitized in the A/D converter **303,** is taken to the transmitter block **304,** typically to the speech coding device comprised by the transmit block. The transmission signal, which is processed, modulated and amplified by the transmit block, is taken via the transmit/receive switch **308** to the antenna **309.** The signal to be received is taken from the antenna via the transmit/receive switch **308** to the receiver block **311,** which demodulates the received signal. The decoding block **320** is capable of converting packet data in the demodulated received signal into an AAC bistream containing a plurality of frames. The error concealment modules, based on the data stored in the buffers, recover the lost data in a defective frame. The error-concealed PCM samples are fed to a playback device **312.** The control unit **305** controls the operation of the mobile terminal **300,** reads the control commands given by the user from the keypad **307** and gives messages to the user by means of the display **306.**

Thus, although the invention has been described with respect to a preferred embodiment thereof, it will be understood by those skilled in the art that the foregoing and various other changes, omissions and deviations in the form and detail thereof may be made without departing from the scope of this invention.

**Claims**

1. An audio decoder for decoding a bitstream indicative of audio signals for providing decoded audio data , wherein the bitstream comprises a current frame and at least one neighboring frame, each frame having a plurality of data parts, said decoder comprising a first module for decoding said each frame for providing a signal indicative of the plurality of data parts in a compressed domain, the data parts including a header, said decoder **characterized by**
   a second module, responsive to the signal, for storing said plurality of data parts including the header in the compressed domain in said at least one neighboring frame, and by
   a third module for detecting at least one defective data part in the compressed domain if the current frame is defective, so as to recover said at least one defective data part in the current frame based on at least one of the stored data parts in said at least one neighboring frame;
   wherein the at least one defective data part in the current frame includes at least one of a window sequence, a window shape, a global gain value, and a plurality of transform coefficients.

2. The audio decoder of claim 1, wherein said at least one defective data part in the current frame includes a window sequence, and said second module is for storing the window sequence in said at least one neighboring frame, and the third module is for recovering said at least one defective data part in the current frame.

3. The audio decoder of claim 1, wherein said at least one defective data part in the current frame includes a window shape, and said second module is for storing the window shape in said at least one neighboring frame, and the third module is for recovering said at least one defective data part in the current frame.

4. The audio decoder of claim 1, wherein said at least one defective data part in the current frame includes a global gain value, and said second module is for storing the global gain value in said at least one neighboring frame, and the third module is for recovering said at least one defective data part in the current frame.

5. The audio decoder of claim 1, wherein said at least one defective data part in the current frame includes a global gain value, and said second module is for storing the at least one neighboring frame including a first frame having a first global gain value and a second frame having a second global gain value smaller than the first global gain value, and that the third module is for recovering at least one defective data part in the current frame i based on the second global gain value.

6. The audio decoder of claim 1, wherein said at least one defective data part in the current frame includes a plurality of transform coefficients, and said second module is for storing the plurality of transform coefficients in said at least one neighboring frame, and that the third module is for recovering said at least one defective data part in the current frame.

7. The audio decoder of claim 6, wherein the transform coefficients comprise QMDCT coefficients.

8. The audio decoder of claim 7, wherein the QMDCT coefficients comprises coefficients in a higher frequency region and a lower frequency region, wherein the third module is for recovering the coefficients in the lower frequency region of the defective data part based on the corresponding coefficients in the lower frequency region in said at least one neighboring frame.

9. An audio receiver (311) adapted to receive packet data in audio streaming, said receiver comprising an unpacking module for unpacking the received packet data into a bitstream indicative of audio signals, wherein the bitstream comprises a current frame and at least one neighboring frame, each frame having a plurality of data parts, said receiver comprising an audio decoder according to any of claims 1 to 8, for decoding said each frame for providing a signal indicative of the plurality of data parts in a compressed domain.

10. A mobile terminal (300) comprising an antenna (309), and an audio receiver (311) connected to the antenna for receiving packet data in audio streaming, wherein the receiver comprises an unpacking module for unpacking the received packet data into a bitstream indicative of audio signals, wherein the bitstream comprises a current frame and at least one neighboring frame, each frame having a plurality of data parts, wherein said receiver further comprises:

an audio decoder (320) according to any of claims 1 to 8.

11. A method of decoding a bitstream indicative of audio signals for providing decoded audio data , wherein the bitstream comprises a current frame and at least one neighboring frame, each frame having a plurality of data parts, the method comprising:

decoding said each frame for providing a signal indicative of the plurality of data parts in a compressed domain, the data parts including a header;

storing said plurality of data parts including the header in the compressed domain in said at least one neighboring frame;

detecting at least one defective data part in the compressed domain if the current frame is defective; and

recovering said at least one defective data part in the current frame based on at least one of the stored data parts in said at least one neighboring frame;

wherein the at least one defective data part in the current frame includes at least one of a window sequence, a window shape, a global gain value, and a plurality of transform coefficients.

12. The method of claim 11, wherein said at least one defective data part in the current frame includes a window sequence, and said at least one of the stored data parts includes the window sequence in said at least one neighboring frame for recovering said at least one defective data part in the current frame.

13. The method of claim 11, wherein said at least one defective data part in the current frame includes a window shape, and said at least one of the stored data parts includes the window shape in said at least one neighboring frame for recovering said at least one defective data part in the current frame.

14. The method of claim 11, wherein said at least one defective data part in the current frame includes a global gain value, and said at least one of the stored data parts include the global gain value in said at least one neighboring frame for recovering said at least one defective data part in the current frame.

15. The method of claim 11, wherein said at least one defective data part in the current frame includes a global gain value, and said at least one neighboring frame includes a first frame having a first global gain value and a second frame having a second global gain value smaller than the first global gain value, and that said at least one defective data part in the current frame is recovered based on the second global gain value.

**Patentansprüche**

1. Audiodecoder zum Decodieren eines Bitstroms, der Audiosignale repräsentiert, um decodierte Audiodaten bereitzustellen, wobei der Bitstrom einen aktuellen Rahmen und wenigstens einen benachbarten Rahmen umfasst und wobei jeder Rahmen mehrere Datenabschnitte hat, wobei der Decoder ein erstes Modul zum Decodieren jedes der Rahmen umfasst, um ein Signal bereitzustellen, das die mehreren Datenabschnitte in einem komprimierten Format repräsentiert, wobei die Datenabschnitte einen Header umfassen und wobei der Decoder durch Folgendes gekennzeichnet ist:

ein zweites Modul, das das Signal als Eingang hat, zum Speichern der mehreren Datenabschnitte in dem wenigstens einen benachbarten Rahmen, die den Header umfassen, im komprimierten Format, und durch

ein drittes Modul zum Detektieren von wenigstens einem fehlerhaften Datenabschnitt im komprimierten Format falls der aktuelle Rahmen fehlerhaft ist, um hierdurch den wenigstens einen fehlerhaften Datenabschnitt im aktuellen Rahmen basierend auf wenigstens einem der gespeicherten Datenabschnitte in dem wenigstens einen benachbarten Rahmen wiederherzustellen;

wobei der wenigstens eine fehlerhafte Datenabschnitt im aktuellen Rahmen wenigstens eines der folgenden Elemente umfasst: eine Fenstersequenz, eine Fensterform, einen Global-Gain-Wert und mehrere Transformationskoeffizienten.

2. Audiodecoder nach Anspruch 1, wobei der wenigstens eine fehlerhafte Datenabschnitt im aktuellen Rahmen eine Fenstersequenz umfasst und das zweite Modul dafür vorgesehen ist, die Fenstersequenz in dem wenigstens einen benachbarten Rahmen zu speichern, und das dritte Modul dafür vorgesehen ist, den wenigstens einen fehlerhaften Datenabschnitt im aktuellen Rahmen wiederherzustellen.

3. Audiodecoder nach Anspruch 1, wobei der wenigstens eine fehlerhafte Datenabschnitt im aktuellen Rahmen eine Fensterform umfasst und das zweite Modul dafür vorgesehen ist, die Fensterform in dem wenigstens einen benachbarten Rahmen zu speichern, und das dritte Modul dafür vorgesehen ist, den wenigstens einen fehlerhaften Datenabschnitt im aktuellen Rahmen wiederherzustellen.

4. Audiodecoder nach Anspruch 1, wobei der wenigstens eine fehlerhafte Datenabschnitt im aktuellen Rahmen einen Global-Gain-Wert umfasst und das zweite Modul dafür vorgesehen ist, den Global-Gain-Wert in dem wenigstens einen benachbarten Rahmen zu speichern, und das dritte Modul dafür vorgesehen ist, den wenigstens einen fehlerhaften Datenabschnitt im aktuellen Rahmen wiederherzustellen.

5. Audiodecoder nach Anspruch 1, wobei der wenigstens eine fehlerhafte Datenabschnitt im aktuellen Rahmen einen Global-Gain-Wert umfasst und das zweite Modul dafür vorgesehen ist, den wenigstens einen benachbarten Rahmen zu speichern, der einen ersten Rahmen mit einem ersten Global-Gain-Wert und einen zweiten Rahmen mit einem zweiten Global-Gain-Wert, der kleiner ist als der erste Global-Gain-Wert, umfasst, und das dritte Modul dafür vorgesehen ist, basierend auf dem zweiten Global-Gain-Wert wenigstens einen fehlerhaften Datenabschnitt im aktuellen Rahmen i wiederherzustellen.

6. Audiodecoder nach Anspruch 1, wobei der wenigstens eine fehlerhafte Datenabschnitt im aktuellen Rahmen mehrere Transformationskoeffizienten umfasst und das zweite Modul dafür vorgesehen ist, die mehreren Transformationskoeffizienten in dem wenigstens einen benachbarten Rahmen zu speichern, und das dritte Modul dafür vorgesehen ist, den wenigstens einen fehlerhaften Datenabschnitt im aktuellen Rahmen wiederherzustellen.

7. Audiodecoder nach Anspruch 6, wobei die Transformationskoeffizienten QMDCT-Koeffizienten umfassen.

8. Audiodecoder nach Anspruch 7, wobei die QMDCT-Koeffizienten Koeffizienten in einem höheren Frequenzbereich und in einem niedrigeren Frequenzbereich umfassen, wobei das dritte Modul dafür vorgesehen ist, die Koeffizienten im niedrigeren Frequenzbereich des fehlerhaften Datenabschnitts basierend auf den entsprechenden Koeffizienten im niedrigeren Frequenzbereich in dem wenigstens einen benachbarten Rahmen wiederherzustellen.

9. Audioempfänger (311), der dafür eingerichtet ist, Paketdaten aus einem Audiostreaming zu empfangen, wobei der Empfänger ein Entpackungsmodul umfasst, zum Entpacken der empfangenen Paketdaten in einen Bitstrom, der Audiosignale repräsentiert, wobei der Bitstrom einen aktuellen Rahmen und wenigstens einen benachbarten Rahmen umfasst und wobei jeder Rahmen mehrere Datenabschnitte hat, wobei der Empfänger Folgendes umfasst:

einen Audiodecoder nach einem der Ansprüche 1 bis 8 zum Decodieren jedes der Rahmen, um ein Signal bereitzustellen, das die mehreren Datenabschnitte in einem komprimierten Format repräsentiert.

10. Mobilfunkendgerät (300), Folgendes umfassend:

eine Antenne (309), und
einen Audioempfänger (311), der an die Antenne angeschlossen ist, um Paketdaten aus einem Audiostreaming zu empfangen, wobei der Empfänger ein Entpackungsmodul umfasst, zum Entpacken der empfangenen Paketdaten in einen Bitstrom, der Audiosignale repräsentiert, wobei der Bitstrom einen aktuellen Rahmen und wenigstens einen benachbarten Rahmen umfasst und wobei jeder Rahmen mehrere Datenabschnitte hat, wobei der Empfänger außerdem Folgendes umfasst:

einen Audiodecoder (320) nach einem der Ansprüche 1 bis 8.

11. Verfahren zum Decodieren eines Bitstroms, der Audiosignale repräsentiert, um decodierte Audiodaten bereitzustellen, wobei der Bitstrom einen aktuellen Rahmen und wenigstens einen benachbarten Rahmen umfasst und wobei jeder Rahmen mehrere Datenabschnitte hat, wobei das Verfahren Folgendes umfasst:

Decodieren jedes der Rahmen, um ein Signal bereitzustellen, das die mehreren Datenabschnitte in einem komprimierten Format repräsentiert, wobei die Datenabschnitte einen Header umfassen;
Speichern der mehreren Datenabschnitte in dem wenigstens einen benachbarten Rahmen, die den Header umfassen, im komprimierten Format;
Detektieren wenigstens eines fehlerhaften Datenabschnitts im komprimierten Format falls der aktuelle Rahmen fehlerhaft ist; und
Wiederherstellen des wenigstens einen fehlerhaften Datenabschnitts im aktuellen Rahmen basierend auf wenigstens einem der gespeicherten Datenabschnitte in dem wenigstens einen benachbarten Rahmen;
wobei der wenigstens eine fehlerhafte Datenabschnitt im aktuellen Rahmen wenigstens eines der folgenden Elemente umfasst: eine Fenstersequenz, eine Fensterform, einen Global-Gain-Wert und mehrere Transformationskoeffizienten.

12. Verfahren nach Anspruch 11, wobei der wenigstens eine fehlerhafte Datenabschnitt im aktuellen Rahmen eine Fenstersequenz umfasst und der wenigstens eine der gespeicherten Datenabschnitte die Fenstersequenz in dem wenigstens einen benachbarten Rahmen umfasst, um den wenigstens einen fehlerhaften Datenabschnitt im aktuellen Rahmen wiederherzustellen.

13. Verfahren nach Anspruch 11, wobei der wenigstens eine fehlerhafte Datenabschnitt im aktuellen Rahmen eine Fensterform umfasst und der wenigstens eine der gespeicherten Datenabschnitte die Fensterform in dem wenigstens einen benachbarten Rahmen umfasst, um den wenigstens einen fehlerhaften Datenabschnitt im aktuellen Rahmen wiederherzustellen.

14. Verfahren nach Anspruch 11, wobei der wenigstens eine fehlerhafte Datenabschnitt im aktuellen Rahmen einen Global-Gain-Wert umfasst und der wenigstens eine der gespeicherten Datenabschnitte den Global-Gain-Wert in dem wenigstens einen benachbarten Rahmen umfasst, um den wenigstens einen fehlerhaften Datenabschnitt im aktuellen Rahmen wiederherzustellen.

15. Verfahren nach Anspruch 11, wobei der wenigstens eine fehlerhafte Datenabschnitt im aktuellen Rahmen einen Global-Gain-Wert umfasst und der wenigstens eine benachbarte Rahmen einen ersten Rahmen mit einem ersten Global-Gain-Wert und einen zweiten Rahmen mit einem zweiten Global-Gain-Wert, der kleiner ist als der erste Global-Gain-Wert, umfasst, und wobei der wenigstens eine fehlerhafte Datenabschnitt im aktuellen Rahmen basierend auf dem zweiten Global-Gain-Wert wiederhergestellt wird.

## Revendications

1. Décodeur audio pour décoder un flot binaire indicatif de signaux audio pour fournir des données audio décodées, dans lequel le flot binaire comprend une trame actuelle et au moins une trame voisine, chaque trame comportant une pluralité de parties de données, ledit décodeur comprenant un premier module pour décoder chaque trame pour fournir un signal indicatif de la pluralité de parties de données dans un domaine compressé, les parties de données comprenant un en-tête, ledit décodeur étant **caractérisé par**
un deuxième module, sensible au signal, pour mémoriser ladite pluralité de parties de données comprenant l'en-tête dans le domaine compressé dans ladite au moins une trame voisine, et par
un troisième module pour détecter au moins une partie de données défectueuse dans le domaine compressé si la trame actuelle est défectueuse, de manière à récupérer ladite au moins une partie de données défectueuse dans la trame actuelle sur la base d'au moins l'une des parties de données mémorisées dans ladite au moins une trame voisine ;
dans lequel ladite au moins une partie de données défectueuse dans la trame actuelle comprend au moins l'une d'une séquence de fenêtre, d'une forme de fenêtre, d'une valeur de gain globale et d'une pluralité de coefficients de transformation.

2. Décodeur audio selon la revendication 1, dans lequel ladite au moins une partie de données défectueuse dans la trame actuelle comprend une séquence de fenêtre, et ledit deuxième module sert à mémoriser la séquence de fenêtre dans ladite au moins une trame voisine, et le troisième module sert à récupérer ladite au moins une partie de données défectueuse dans la trame actuelle.

3. Décodeur audio selon la revendication 1, dans lequel ladite au moins une partie de données défectueuse dans la trame actuelle comprend une forme de fenêtre, et ledit deuxième module sert à mémoriser la forme de fenêtre dans ladite au moins une trame voisine, et le troisième module sert à récupérer ladite au moins une partie de données défectueuse dans la trame actuelle.

4. Décodeur audio selon la revendication 1, dans lequel ladite au moins une partie de données défectueuse dans la trame actuelle comprend une valeur de gain globale, et ledit deuxième module sert à mémoriser la valeur de gain globale dans ladite au moins une trame voisine, et le troisième module sert à récupérer ladite au moins une partie de données défectueuse dans la trame actuelle.

5. Décodeur audio selon la revendication 1, dans lequel ladite au moins une partie de données défectueuse dans la trame actuelle comprend une valeur de gain globale, et ledit deuxième module sert à mémoriser ladite au moins une trame voisine comprenant une première trame ayant une première valeur de gain globale et une deuxième trame ayant une deuxième valeur de gain globale inférieure à la première valeur de gain globale, et le troisième module sert à récupérer au moins une partie de données défectueuse dans la trame actuelle i sur la base de la deuxième valeur de gain globale.

6. Décodeur audio selon la revendication 1, dans lequel ladite au moins une partie de données défectueuse dans la trame actuelle comprend une pluralité de coefficients de transformation, et ledit deuxième module sert à mémoriser la pluralité de coefficients de transformation dans ladite au moins une trame voisine, et le troisième module sert à récupérer ladite au moins une partie de données défectueuse dans la trame actuelle.

7. Décodeur audio selon la revendication 6, dans lequel les coefficients de transformation comprennent des coefficients QMDCT.

8. Décodeur audio selon la revendication 7, dans lequel les coefficients QMDCT comprennent des coefficients dans une région de fréquence supérieure et une région de fréquence inférieure, dans lequel le troisième module sert à récupérer les coefficients dans la région de fréquence inférieure de la partie de données défectueuse sur la base des coefficients correspondants dans la région de fréquence inférieure dans ladite au moins une trame voisine.

9. Récepteur audio (311) conçu pour recevoir des données de paquets dans une transmission audio en continu, ledit récepteur comprenant un module de désassemblage de paquets pour désassembler les données de paquets reçues en un flot binaire indicatif de signaux audio, dans lequel le flot binaire comprend une trame actuelle et au moins une trame voisine, chaque trame comportant une pluralité de parties de données, ledit récepteur comprenant :

un décodeur audio selon l'une quelconque des revendications 1 à 8, pour décoder chaque dite trame pour fournir un signal indicatif de la pluralité de parties de données dans un domaine compressé.

10. Terminal mobile (300) comprenant :

une antenne (309), et
un récepteur audio (311) connecté à l'antenne pour recevoir des données de paquets dans une transmission audio en continu, dans lequel le récepteur comprend un module de désassemblage de paquets pour désassembler les données de paquets reçues en un flot binaire indicatif de signaux audio, dans lequel le flot binaire comprend une trame actuelle et au moins une trame voisine, chaque trame comportant une pluralité de parties de données, dans lequel ledit récepteur comprend en outre :

un décodeur audio (320) selon l'une quelconque des revendications 1 à 8.

11. Procédé de décodage d'un flot binaire indicatif de signaux audio pour fournir des données audio décodées, dans lequel le flot binaire comprend une trame actuelle et au moins une trame voisine, chaque trame comportant une pluralité de parties de données, le procédé consistant à :

décoder chaque dite trame pour fournir un signal indicatif de la pluralité de parties de données dans un domaine compressé, les parties de données comprenant un en-tête ;
mémoriser ladite pluralité de parties de données comprenant l'en-tête dans le domaine compressé dans ladite au moins une trame voisine ;
détecter au moins une partie de données défectueuse dans le domaine compressé si la trame actuelle est défectueuse ; et
récupérer ladite au moins une partie de données défectueuse dans la trame actuelle sur la base d'au moins l'une des parties de données mémorisées dans ladite au moins une trame voisine ;
dans lequel ladite au moins une partie de données défectueuse dans la trame actuelle comprend au moins une séquence de fenêtre, une forme de fenêtre, une valeur de gain globale et/ou une pluralité de coefficients de transformation.

**12.** Procédé selon la revendication 11, dans lequel ladite au moins une partie de données défectueuse dans la trame actuelle comprend une séquence de fenêtre, et ladite au moins une des parties de données mémorisées comprend la séquence de fenêtre dans ladite au moins une trame voisine pour récupérer ladite au moins une partie de données défectueuse dans la trame actuelle.

**13.** Procédé selon la revendication 11, dans lequel ladite au moins une partie de données défectueuse dans la trame actuelle comprend une forme de fenêtre, et ladite au moins une des parties de données mémorisées comprend la forme de fenêtre dans ladite au moins une trame voisine pour récupérer ladite au moins une partie de données défectueuse dans la trame actuelle.

**14.** Procédé selon la revendication 11, dans lequel ladite au moins une partie de données défectueuse dans la trame actuelle comprend une valeur de gain globale, et ladite au moins une des parties de données mémorisées comprend la valeur de gain globale dans ladite au moins une trame voisine pour récupérer ladite au moins une partie de données défectueuse dans la trame actuelle.

**15.** Procédé selon la revendication 11, dans lequel ladite au moins une partie de données défectueuse dans la trame actuelle comprend une valeur de gain globale, et ladite au moins une trame voisine comprend une première trame ayant une première valeur de gain globale et une deuxième trame ayant une deuxième valeur de gain globale inférieure à la première valeur de gain globale, et ladite au moins une partie de données défectueuse dans la trame actuelle est récupérée sur la base de la deuxième valeur de gain globale.

| Critical data (e.g. header) | Scale factors | Quantized MDCT coefficients (QMDCT data) |
|---|---|---|

## FIG. 1

| Critical data buffer for frame n-1 |
|---|

⬇

| Critical data buffer for frame n |
|---|

⬆

| Critical data buffer for frame n+1 |
|---|

## FIG. 4

EP 1 579 425 B1

Fig. 2

500

AAC bitstream

510
Header error ? — yes → 512 Revise header

no

520
Scalefactor error ? — yes → 522 Revise scalefactor

no

530
QMDCT coefficient error ? — yes → 532 Revise QMDCT coefficients

no

Main data decoding — 540

PCM samples

Error handing

Fig. 3

| Scale factors for frame n-1, left channel |
|---|

d1          d2

| Scale factors for frame n-1, right channel |
|---|

frame n-1

| Scale factors for frame n, left channel |
|---|

| Lost scale factors for frame n, right channel |
|---|

frame n

# FIG. 5

FIG. 6

EP 1 579 425 B1

FIG. 7

Legend:
◇ , a: frame n-1, right channel
* , b: frame n-1, left channel
▽ , c: frame n, right channel
+ , d: frame n, left channel

EP 1 579 425 B1

◇ , a: frame n-1, right channel
* , b: frame n-1, left channel
▽ , c: frame n, right channel
+ , d: frame n, left channel

# FIG. 8

EP 1 579 425 B1

FIG. 9

FIG. 10

EP 1 579 425 B1

FIG. 11A

FIG. 11B

FIG. 12

Data from channel 200 → Packet unpacking 20 → 210 → AAC decoder 10 → 240 PCM Samples → Playback buffer 50 → 250 Playback device

Packet unpacking 20 → 204 → Error checking e.g. sequence number checking 24 → 28 Bad packet or frame indicator → 26 CRC and semantic check

202 → Percussive codebook 22

30 Compressed domain error concealment → Buffer 1 32, Buffer 2 34, Buffer 3 36

40 MDCT domain error concealment → Buffer 4 42

52 PCM domain Error concealment → Reproduced PCM Samples

206

5

FIG. 13

EP 1 579 425 B1

**EP 1 579 425 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 20040083110 A1
- WO 9813965 A
- WO 9813965 A1
- US 281395 A

### Non-patent literature cited in the description

- **KORHONEN.** Error Robustness Scheme for Perceptually Coded Audio Based on Interframe Shuffling of Samples. *Proc, of IEEE International Conference on Acoustics, Speech and Signal Processing,* May 2002, 2053-2056
- **HEIKO PURNHAGEN.** *An Overview of Mpeg-4 Audio Version 2,* 1999